# EUROPEAN PATENT APPLICATION

(11) **EP 2 246 917 A2**
(43) Date of publication of application: **03.11.2010**
(21) Application number: 10160646.5
(22) Date of filing: 21.04.2010
(51) Int. Cl.: H01L 51/42

(54) **An electron collector and its application in photovoltaics**

(30) Priority: 30.04.2009 US 433560
(71) Applicant: Honeywell International Inc., Morristown, NJ 07962 (US)
(72) Inventor: Zheng, Zhi, 200030, Shanghai (CN); Tang, Huili, Morristown, NJ 07962-2245 (US); Wang, Marilyn, 201203, Pudong New Area Shanghai (CN); Zhao, Linan, 201204, Pudong New Area Shanghai (CN); Liu, Xuanbin, 201702, Shanghai (CN)
(74) Representative: Buckley, Guy Julian

(57) **Abstract**

Photovoltaic cells (10) and methods for manufacturing photovoltaic cells (10). An example photovoltaic cell (10) may include an electron conductor (14), a hole conductor (22) and an active region (20) situated therebetween. The electron conductor (14) may include a nanowire array (16) and a sheath (18) disposed over the nanowire array (16). The nanowire array (16) may include a material having an electron mobility that is greater than the electron mobility of the sheath (18). The sheath (18) may have a density of states that is greater than the density of states of the nanowire array (16).

## Description

### Technical Field

The disclosure pertains generally to photovoltaics and/or photovoltaic cells. More particularly, the disclosure pertains to photovoltaic cells and methods for manufacturing the same.

### Background

A wide variety of photovoltaics (and/or photovoltaic cells) have been developed for converting sunlight into electricity (e.g. solar cells). Of the known photovoltaics, each has certain advantages and disadvantages. There is an ongoing need to provide alternative photovoltaics and/or photovoltaic cells as well as alternative methods for manufacturing photovoltaics and/or photovoltaic cells.

### Summary

The disclosure relates generally to photovoltaic cells. In some instances, photovoltaic cells may be solar cells. An example photovoltaic cell may include an electron conductor, a hole conductor, and an active region situated between the electron conductor and the hole conductor. In some illustrative embodiments, the electron conductor may include a nanowire array and a sheath disposed over the nanowire array. The nanowire array may include a material having a relatively high electron mobility for good electron transport. In some cases, the electron mobility of the nanowire array may be greater than 30cm²/V/s, greater than 100cm²/V/s, greater than 200cm²/V/s, or higher, as desired. The sheath may include a material having a relatively high density of states for good acceptance of electrons from the active region. In some cases, the nanowire array may include ZnO and the sheath may be TiO₂, but this is not required.

The above summary of some embodiments is not intended to describe each disclosed embodiment or every implementation of the present invention. The Figures, and Description which follow more particularly exemplify certain illustrative embodiments.

### Brief Description of the Drawing

The invention may be more completely understood in consideration of the following detailed description of various embodiments of the invention in connection with the accompanying drawing, in which:

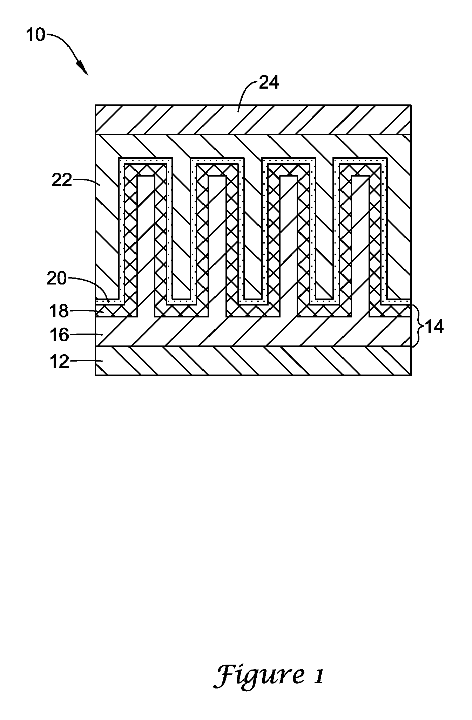

Figure 1 is a schematic side view of an example photovoltaic cell.

While the invention is amenable to various modifications and alternative forms, specifics thereof have been shown by way of example in the drawing and will be described in detail. It should be understood, however, that the intention is not to limit the invention to the particular embodiments described. On the contrary, the intention is to cover all modifications, equivalents, and alternatives falling within the spirit and scope of the invention.

### Description

For the following defined terms, these definitions shall be applied, unless a different definition is given in the claims or elsewhere in this specification.

All numeric values are herein assumed to be modified by the term "about," whether or not explicitly indicated. The term "about" generally refers to a range of numbers that one of skill in the art would consider equivalent to the recited value (i.e., having the same function or result). In many instances, the terms "about" may include numbers that are rounded to the nearest significant figure.

The recitation of numerical ranges by endpoints includes all numbers within that range (e.g. 1 to 5 includes 1, 1.5, 2, 2.75, 3, 3.80, 4, and 5).

As used in this specification and the appended claims, the singular forms "a", "an", and "the" include plural referents unless the content clearly dictates otherwise. As used in this specification and the appended claims, the term "or" is generally employed in its sense including "and/or" unless the content clearly dictates otherwise.

The following description should be read with reference to the drawing. The drawing, which is not necessarily to scale, depicts an illustrative embodiment that is not intended to limit the scope of the invention.

A wide variety of photovoltaics (and/or photovoltaic cells) have been developed for converting sunlight or other light into electricity. Some example photovoltaics include a layer of crystalline silicon. Second and third generation photovoltaics often use a thin film(s) of photovoltaic material deposited or otherwise provided on a substrate. Thin-film photovoltaics may be categorized according to the photovoltaic material deposited. For example, inorganic thin-film photovoltaics may include a thin film of amorphous silicon, microcrystalline silicon, CdS, CdTe, Cu₂S, copper indium diselenide (CIS), copper indium gallium diselenide (CIGS), etc. Similarly, organic thin-film photovoltaics may include a thin film of a polymer or polymers, bulk heterojunctions, ordered heterojunctions, a fullerence, a polymer/fullerence blend, photosynthetic materials, etc. These are only examples.

Efficiency may play an important role in the design and production of photovoltaics. One factor that may correlate to efficiency may be the composition of the electron conductor. In general, the electron conductor may function by collecting electrons generated in the active photovoltaic region and transport them to the anode.

In some photovoltaic cells, n-type semiconductors may be used as the electron conductor. For example, in some photovoltaic cells, the electron conductor may include either ZnO or TiO₂. These materials, however, may limit the efficiency of some photovoltaics. For example, TiO₂ may have an electron mobility that is relatively low (e.g., on the order of about 30 cm²/V/s). This may limit or slow the transportation of electrons, which may result in the likelihood that the electrons will recombined with holes and thus not be transported to the anode and to outside circuit as electricity. Thus, electron conductors made from TiO₂ may be described as having a low collecting or collection efficiency. In another example, an electron conductor that is made from ZnO may have a density of states that is relatively low at the bottom of its conduction band. This may slow the electron transfer rate from the active photovoltaic region to the electron conductor. Thus, electron conductors made from ZnO may be described as having a relatively low electron injection efficiency. Both low collection efficiency and low injection efficiency in a photovoltaic cell may result in a lower incident photon to charge carrier efficiency and/or power conversion efficiency.

Generally, the photovoltaics and/or photovoltaic cells disclosed herein may be made more efficient by, for example, using an electron conductor that increases the collection efficiency and/or the injection efficiency of the cell. The methods for manufacturing photovoltaics and/or photovoltaic cells disclosed herein may be used to produce more efficient photovoltaics.

Figure 1 is a schematic side view of an example photovoltaic cell 10. Cell 10 may include a first substrate or electrode 12 (e.g. anode), an electron conductor 14 including a first component 16 and a second component 18, an active or photovoltaic region 20, a hole conductor 22, and a second substrate or electrode 24 (e.g. cathode). Electrodes and/or substrates 12/24 may be made from any suitable material. In one example, electrodes and/or substrates 12/24 may include fluoride-doped tin oxide glass or other suitable glass. In at least some embodiments, and as indicated above, electrode 12 is the anode and electrode 24 is the cathode.

The illustrative electron conductor 14 may include a first component 16 and a second component 18. The first component 16 may include a nanowire array. The second component 18 may include a sheath over the nanowire array. Nanowire array 16 may include an array of nanowires or cores that are made from a material with a relatively high electron mobility. In some cases, the nanowire array 16 may have an electron mobility that is higher than the electron mobility of the first component 18 (e.g. higher than TiO₂, which has an electron mobility of about 30 cm²/V/s). In some cases, the electron mobility of the nanowire array 16 may be greater than 30cm²/V/s, greater than 100cm²/V/s, greater than 200cm²/V/s, or higher, as desired. In some cases, nanowire array 16 may include ZnO, which may have an electron mobility on the order of about 200 cm²/V/s.

The second component 18 may include a sheath that extends over the nanowire array 16. The sheath may include a material that has a relatively high density of states at the bottom of its conduction band. In one example, it may be desirable for sheath 18 to have a density of states that is higher than the density of states of the second component 18 (e.g. higher than the density of states of ZnO), but this is not required. In some cases, sheath 18 may include TiO₂, which has a conduction band of about 0.2 eV higher than that of ZnO. TiO₂ may have a conduction band formed from empty 3d orbitals of Ti⁴⁺. Conversely, ZnO may have a conduction band formed from empty 4s orbitals of Zn²⁺. Because of this, the effective mass of electrons in TiO₂ may be about 10_{Me} whereas in ZnO is may be about 0.3_{Me}. This may lead to a higher bulk density of states (e.g., about 190 times higher) in TiO₂ than in ZnO. Thus, the electrons collected in the TiO₂ sheath 18 from active region 20 may more easily flow down to the conduction band of the ZnO nanowire array 16, and may not be able to easily jump back across this energy barrier.

During operation, electrons may first be injected from active region 20 to sheath 18. Electrons may then be transported along sheath 18 and transferred to nanowire array 16. Finally, the electrons may be transferred along nanowire array 16 to electrode 12 (e.g. the anode). The electron injection efficiency of the sheath 18 and the electron collection or transport efficiency of the nanowire array 18 may both be utilized, which may increase the incident photons to charge carrier efficiency and/or power conversion efficiency of cell 10.

An illustrative method for manufacturing the illustrative electron conductor 14 may include a two-step process. The first step may include the growth of nanowire array 16. This may include chemical growth, although electrochemical and/or physical growth may also be utilized as desired. In one example, substrate 12 may be seeded with zinc acetate in ethanol. Substrate 12 may be annealed (e.g., heated) in order to align the crystal seeds on substrate 12. After annealing, the seeded substrate 12 may be immersed in an aqueous solution of Zn(NO₃)₂ and NaOH and heated. This may result in the growth of ZnO nanowires (e.g., nanowire array 16) on substrate 12. After the desired amount of growth is achieved, substrate 12 (having nanowire array 16 formed thereon) may be washed with deionized water and air dried.

The second step may include the growth of sheath 18 on nanowire array 18. This may include a liquid phase deposition, although sputtering and/or evaporation may also be utilized as desired. In one example, ammonium hexafluorotitanate may be dissolved in deionized water and mixed with boric acid to form a TiO₂ sheath solution. Substrate 12 (having nanowire array 16 formed thereon) may be immersed in the TiO₂ sheath solution so that sheath 16 is formed on nanowire array 14.

Alternative methods may also be used to form electron conductor 14. For example, electron conductor 14 may be formed using a sol-gel method. According to this method, after substrate 12 is prepared with nanowire array 16 thereon, a TiO₂ sol is coated and/or dip coated onto nanowire array 16 and then dried and sintered to form the TiO₂ sheath 18. It will be appreciated that other methods may be used for forming a suitable electron conductor 14.

Active region 20 may vary widely in composition depending on the type of photovoltaic cell desired. For example, active region 20 may include a (e.g., thin) film or layer of crystalline silicon, amorphous silicon, microcrystalline silicon, CdS, CdTe, Cu₂S, a transparent conductive oxide, copper indium diselenide (CIS), copper indium gallium diselenide (CIGS), etc., a polymer or polymers, bulk heterojunctions, ordered heterojunctions, a fullerence, a polymer/fullerence blend, photosynthetic materials, extremely thin-layer absorbers (ETA), hybrid materials or layers, a photosensitive dye, combinations thereof, and the like, or any other suitable active region 20. Numerous variations are contemplated for active region 20 including the use or inclusion of essentially any suitable photovoltaic material including essentially any suitable thin-film photovoltaic.

In some embodiments, active region 20 may include a quantum dot or a plurality of quantum dots. Quantum dots are typically very small semiconductors, having dimensions in the nanometer range. Because of their small size, quantum dots may exhibit quantum behavior that is distinct from what would otherwise be expected from a larger sample of the material. In some cases, quantum dots may be considered as being crystals composed of materials from Groups II-VI, III-V, or IV-VI materials. The quantum dots employed may be formed using any appropriate technique. Examples of specific pairs of materials for forming quantum dots include, but are not limited to, MgO, MgS, MgSe, MgTe, CaO, CaS, CaSe, CaTe, SrO, SrS, SrSe, SrTe, BaO, BaS, BaSe, BaTe, ZnO, ZnS, ZnSe, ZnTe, CdO, CdS, CdSe, CdTe, HgO, HgS, HgSe, HgTe, Al₂O₃, Al₂S₃, Al₂Se₃, Al₂Te₃, Ga₂O₃, Ga₂S₃ Ga₂Se₃ Ga₂Te₃, In₂O₃, In₂S₃, In₂Se₃, In₂Te₃, SiO₂, GeO₂, SnO₂, SnS, SnSe, SnTe, PbO, PbO₂, PbS, PbSe, PbTe, AIN, AlP, AlAs, AlSb, GaN, GaP, GaAs, GaSb, InN, InP, InAs and InSb.

The size or thickness of active region 20 may also vary. In at least some embodiments, active region 20 may have a thickness in the micrometer range (e.g., about 0.1 to about 10 micrometers). In other embodiments, active region 20 may be in the nanometer range (e.g., about 0.1 to about 10 nanometers). In still other embodiments, active region 20 may fall between the micrometer range and the nanometer range or fall outside of the given ranges. It can be appreciated that active region 20 may be configured so as to have essentially any suitable thickness.

Hole conductor 22 may be configured to reduce active region 20 once active region 20 has absorbed a photon and ejected an electron to electron conductor 14. In at least some embodiments, hole conductor 22 may include a p-type conductor. In some instances, hole conductor 22 may be a conductive polymer, but this is not required. The conductive polymer may, for example, be or otherwise include a functionalized polythiophene.

An illustrative but non-limiting example of a suitable conductive polymer has 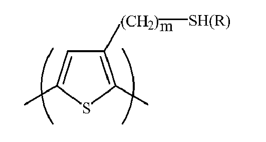 as a repeating unit, where R is absent or alkyl and m is an integer ranging from about 6 to about 12. The term "alkyl" refers to a straight or branched chain monovalent hydrocarbon radical having a specified number of carbon atoms. Examples of "alkyl" include, but are not limited to, methyl, ethyl, n-propyl, isopropyl, n-butyl, s-butyl, t-butyl, n-pentyl, n-hexyl, 3-methylpentyl, and the like.

Another illustrative but non-limiting example of a suitable conductive polymer has 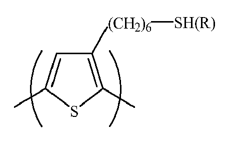 as a repeating unit, where R is absent or alkyl.
Another illustrative but non-limiting example of a suitable conductive polymer has 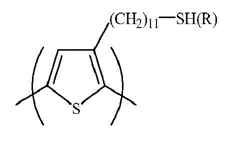 as a repeating unit, where R is absent or alkyl.
Another illustrative but non-limiting example of a suitable conductive polymer has 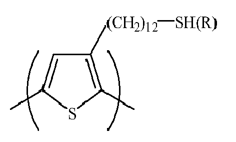 as a repeating unit, where R is absent or alkyl.

The methods for manufacturing cell 10 may include providing substrate 12 and disposing electron conductor 14 (e.g., which may be formed as discussed herein) onto substrate. Active region 20 and hole conductor 22 may also be provided and arranged so that active region 20 is disposed between electron conductor 14 and hole conductor 22.

While the cells 10 and method for manufacturing cells 10 disclosed herein are described in terms of photovoltaic cells, it can be appreciated that this disclosure is also applicable to other thin-film devices such as light emitting diodes (LED's). Consequently, to the extent applicable, this disclosure may analogously by applied to LED and other thin film devices, if desired.
It should be understood that this disclosure is, in many respects, only illustrative. Changes may be made in details, particularly in matters of shape, size, and arrangement of steps without exceeding the scope of the invention. The invention's scope is, of course, defined in the language in which the appended claims are expressed.

## Claims

1. A photovoltaic cell (10), comprising:
an electron conductor (14), the electron conductor (14) including a nanowire array (16) and a sheath (18) disposed over the nanowire array (16);
wherein the nanowire array (16) includes a material having an electron mobility greater than 30cm²/V/s, and the sheath (18) includes a material that has a density of states that is higher than the density of states of the material of the nanowire array (16);
a hole conductor (22); and
an active region (20) disposed between the electron conductor (14) and the hole conductor (22).

2. The photovoltaic cell (10) of claim 1, wherein the nanowire array (16) includes ZnO.

3. The photovoltaic cell (10) of any one of claims 1-2, wherein the sheath (18) includes TiO₂.

4. The photovoltaic cell (10) of any one of claims 1-3, wherein the hole conductor (22) comprises a conductive polymer.

5. The photovoltaic cell (10) of claim 4, wherein the conductive polymer comprises 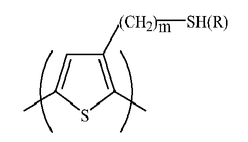 as a repeating unit, where R is absent or alkyl and m is an integer ranging from about 6 to about 12.

6. The photovoltaic cell (10) of any one of claims 1-5, wherein the active region (20) includes a thin-film photovoltaic layer.

7. The photovoltaic cell (10) of any one of claims 1-6, wherein the active region (20) includes a photosensitive dye.

8. The photovoltaic cell (10) of any one of claims 1-7, wherein the active region (20) includes a quantum dot.

9. The photovoltaic cell (10) of any one of claims 1-8, wherein the active region (20) includes a polymer.

10. The photovoltaic cell (10) of any one of claims 1-9, wherein the active region (20) includes poly-3-hexylthiophene.

11. A photovoltaic cell (10), comprising:
an electron conductor (14), the electron conductor (14) including an array of ZnO nanowires (16) and a TiO₂ sheath (18) over the ZnO nanowires (16);
a hole conductor (22); and
an active region (20) disposed between the electron conductor (14) and the hole conductor (22).
